# EUROPÄISCHE PATENTANMELDUNG

(11) **EP 1 109 220 A2**
(43) Veröffentlichungstag der Anmeldung: **20.06.2001**
(21) Anmeldenummer: 00126887.9
(22) Anmeldetag: 07.12.2000
(51) Int. Cl.: H01L 23/532

(54) **Dielektrische Füllung von elektrischen Verdrahtungsebenen**

(30) Priorität: 17.12.1999 DE 19961103
(71) Anmelder: Infineon Technologies AG, 81669 München (DE)
(72) Erfinder: Kirchhoff, Markus, Dr., 01458 Ottendorf-Okrilla (DE); Rogalli, Michael, Dr., 84056 Rottenburg (DE); Wege, Stephan, 01474 Weissig (DE)
(74) Vertreter: Fischer, Volker, Dipl.-Ing.

(57) **Zusammenfassung**

Die vorliegende Erfindung betrifft eine dielektrische Füllung für elektrische Verdrahtungsebenen eines integrierten Schaltkreises. Die elektrische Verdrahtung des integrierten Schaltkreises umfaßt einen Grundkörper (1), auf dem bereits Leitungs- und Passivierungsebenen angeordnet sein können; eine leitfähige Schicht (2), die auf dem Grundkörper (1) angeordnet ist und so strukturiert ist, daß sie eine erste Leiterbahn (3), eine zweite Leiterbahn (4) und einen Graben (5) zwischen der ersten Leiterbahn (3) und der zweiten Leiterbahn (4) aufweist; eine erste dielektrische Schicht (6) auf der leitfähigen Schicht (2) angeordnet ist und den Graben (5) zumindest teilweise auffüllt, wobei es sich bei der ersten dielektrischen Schicht (6) um den Polymerwerkstoff Polybenzoxazol handelt.

## Beschreibung

Die vorliegende Erfindung betrifft die dielektrische Füllung von elektrischen Verdrahtungsebenen in einem integrierten Schaltkreis.

Integrierte Schaltkreise bestehen aus einer Vielzahl von Einzelstrukturen, die meist in Schichten auf einem Substrat angeordnet sind. Üblicherweise werden elektronische Bauelemente wie Widerstände, Kapazitäten, Dioden, Transistoren etc. in einem Substrat gefertigt. Die elektrische Verschaltung der einzelnen Bauelemente erfolgt dann in einer oder mehreren darüberliegenden Verdrahtungsebenen (sog. Metallisierungsebenen).

Ein Verfahren, das zur elektrischen Verdrahtung verwendet wird, sieht die Abscheidung einer leitenden Schicht auf einem Substrat vor. Die leitende Schicht wird anschließend photolithographisch strukturiert, so daß Leiterbahnen mit einem dazwischenliegenden Graben entstehen. Üblicherweise wird der Graben mit einem Dielektrikum aus Siliziumoxid aufgefüllt. Dazu werden z.B. dotierte Siliziumoxide wie Borsilikatglas, Phosphorsilikatglas oder Arsensilikatglas bzw. Mischungen aus diesen Materialien verwendet. Die dotierten Silikatglase haben die Eigenschaft, bei hohen Temperaturen zu verfließen. Dadurch ist es möglich, den Graben mit einem isolierenden Dielektrikum aufzufüllen.

Die dotierten Silikatglase haben allerdings den Nachteil, daß sie eine hohe Dielektrizitätskonstante von ca. 4 aufweisen. Die hohe Dielektrizitätskonstante wirkt sich nachteilig auf die Signalausbreitungsgeschwindigkeit auf den elektrischen Verbindungsleitungen aus, die durch die hohe Dielektrizitätskonstante eine große Kapazität aufweisen. Die große Kapazität führt zu großen RC-Zeiten. Das Problem großer RC-Zeiten verschärft sich in der Zukunft, da die Abstände zwischen den einzelnen Leiterbahnen aufgrund des allgemeinen Trends zu immer kleineren Bauelementen, immer weiter abnimmt, was zu grö-ßeren Kapazitäten führt.

Ein weiteres Problem, das mit der stetigen Verkleinerung der elektrischen Schaltkreise einher geht, ist die begrenzte Fließfähigkeit der dotierten Silikatglase. Dadurch entstehen bei immer kleiner werdenden Gräben zwischen den Leiterbahnen sog. Lunker, in die das dotierte Silikatglas nicht mehr hineingelangt. Die Lunker haben die unangenehme Eigenschaft, Feuchtigkeit anzusammeln. Bei einem Temperaturschritt, den der integrierte Schalterkreis z.B. beim Auflöten erfährt, explodiert der integrierte Schaltkreis durch die Verdampfung der angesammelten Feuchtigkeit und wird dadurch unbrauchbar.

Ein weiterer Nachteil besteht in der hohen Reflektivität der dotierten Silikatglasschichten, die bei nachfolgenden lithographischen Schritten zu Fehlbelichtungen und Fehlprozeßierungen führt.

Es ist die Aufgabe der vorliegenden Erfindung, eine dielektrische Schicht für eine elektrische Verdrahtungsebene eines integrierten Schaltkreises anzugeben, die gute Füll- und Verfließeigenschaften, eine niedrige Dielektrizitätskonstante und reflektionsunterdrückende Eigenschaften bei photolithographischen Schritten aufweist.

Erfindungsgemäß wird diese Aufgabe gelöst durch eine elektrische Verdrahtung eines integrierten Schaltkreises mit:
- einem Grundkörper;
- einer leitfähigen Schicht, die auf dem Grundkörper angeordnet ist und so strukturiert ist, daß sie eine erste Leiterbahn, eine zweite Leiterbahn und einen Graben zwischen der ersten Leiterbahn und der zweiten Leiterbahn aufweist;
- einer ersten dielektrischen Schicht, die auf der leitfähigen Schicht angeordnet ist und den Graben zumindest teilweise ausfüllt,
- wobei die erste dielektrische Schicht einen der Polymerwerkstoffe Polybenzoxazol und/oder Polynorbornen und/oder eines ihrer Derivate umfaßt.

Neben Polybenzoxazol sind noch weitere Materialien geeignet, die ebenfalls durch Aufschleuderverfahren (spin on) auf einen Wafer aufgetragen werden können. Dazu gehören anorganische Materialien wie Hydrogen Silsesquioxane und organische Materialien wie Polybenzoxazole, Polyimide, Perylene, Polynorbornene und Polytetrafluorethylen sowie deren Derivate, wie insbesondere deren Fluorierte Derivate.

Betreffend des Verfahrens wird die gestellte Aufgabe gelöst durch ein Verfahren zur Herstellung einer elektrischen Verdrahtung eines integrierten Schaltkreises mit den Schritten:
- Bilden einer leitfähigen Schicht auf einem Grundkörper;
- Strukturieren der leitfähigen Schicht, so daß eine erste Leiterbahn, eine zweite Leiterbahn und ein Graben zwischen der ersten Leiterbahn und der zweiten Leiterbahn gebildet wird,
- wobei eine erste dielektrische Schicht aus einem Polymer auf der leitfähigen Schicht aufgeschleudert wird, so daß der Graben zumindest teilweise aufgefüllt wird, wobei das Polymer Polybenzoxazol und/oder Polynorbornen und/oder eines ihrer Derivate umfaßt.

Bevorzugte Weiterbildungen sind Gegenstand der jeweiligen Unteransprüche.

Der Polymerwerkstoff Polybenzoxazol (PBO) zeichnet sich dadurch aus, daß er durch Schleuderbeschichtung (Spin Coating) aufgebracht werden kann und somit kleinste Spalten lunkerfrei füllt. Dadurch werden Hohlräume vermieden, die in einem HAST-Test (Humidity Accelleration Stress Test) Feuchtigkeit ansammeln und bei nachfolgenden Temperaturschritten explodieren können (Popcorn-Effekt). Neben diesen hervorragenden Planarisierungseigenschaften zeichnet sich Polybenzoxazol nach seiner Aushärtung durch eine hohe Temperaturbeständigkeit bis über 400°Celsius und eine niedrige Feuchteaufnahme aus. Darüber hinaus ist die Dielektrizitätskonstante von Polybenzoxazol im ausgehärteten Zustand kleiner als 2,9. Die geringe Dielektrizitätskonstante ermöglicht aufgrund der geringeren parasitären Kapazitäten schnellere Signale auf dem integrierten Schaltkreis. Weiterhin behindert Polybenzoxazol durch seine Absorptionseigenschaften Reflexionen bei nachfolgenden photolithographischen Belichtungsschritten. Dadurch wird eine wesentlich verbesserte Auflösung bei nachfolgenden photolithographischen Schritten erzielt.

In einer vorteilhaften Ausprägung der erfindungsgemäßen Anordnung ist oberhalb der dielektrischen Schicht eine Siliziumnitridschicht angeordnet. Die Siliziumnitridschicht hat den Vorteil, daß sie als Passivierungsschicht mit hervorragender Sperrwirkung gegen Wasserdampf, Alkaliionen und anderen korrosiv wirkenden Stoffen eingesetzt werden kann.

In einer weiteren vorteilhaften Ausführung der erfindungsgemäßen Anordnung wird zwischen der ersten dielektrischen Schicht und der Siliziumnitridschicht eine Siliziumoxidschicht angeordnet.

In einer weiteren vorteilhaften Ausprägung der erfindungsgemäßen Anordnung ist oberhalb der ersten dielektrischen Schicht eine zweite dielektrische Schicht aus Polybenzoxazol oder einem photosensitiven Polyimid angeordnet.

Ausführungsbeispiele der Erfindung werden nachfolgend anhand der Zeichnungen dargestellt und erläutert.

In den Figuren zeigen:
- Figur 1: einen Schichtaufbau zur elektrischen Verdrahtung gemäß dem Stand der Technik;
- Figur 2: einen erfindungsgemäßen Schichtaufbau.
- Figur 3: einen weiteren erfindungsgemäßen Schichtaufbau.

In den Figuren bezeichnen gleiche Bezugszeichen gleiche oder funktionsgleiche Elemente.

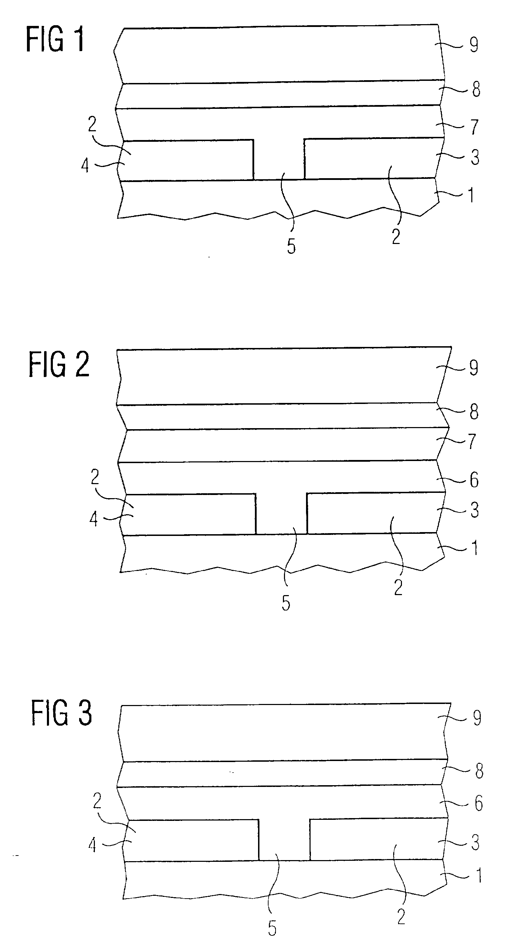

In Figur 1 ist ein Schichtaufbau einer elektrischen Verdrahtung gemäß dem Stand der Technik dargestellt. Auf einem Grundkörper 1, welcher bereits elektronische Bauelemente wie Widerstände, Kapazitäten, Dioden, Transistoren, Passivierungsschichten etc. umfassen kann, wird eine leitfähige Schicht 2 abgeschieden. Üblicherweise wird die leitfähige Schicht 2 aus einem Metall wie Aluminium oder Kupfer gebildet. Die leitfähige Schicht 2 wird so strukturiert, daß eine erste Leiterbahn 3 und eine zweite Leiterbahn 4 mit einem dazwischenliegenden Graben 5 entstehen. Anschließend wird üblicherweise ein dotiertes Silikatglas abgeschieden und mit einem Temperaturschritt so verflossen, daß es den Graben 5 auffüllt und eine Siliziumoxidschicht 7 bildet. Auf der Siliziumoxidschicht 7 wird anschließend eine Siliziumnitridschicht 8 gebildet, die als Passivierungsschicht mit hervorragender Sperrwirkung dient. Anschließend wird eine zweite dielektrische Schicht 9 auf der Siliziumnitridschicht 8 gebildet. Die zweite dielektrische Schicht 9 dient als Photosensitive Schicht (Fotolack) und besteht beispielsweise aus einem Polyimid, einem photosensitiven Polyimid, einem Polyimidderivat, einem Polybenzoxazol, einem photosensitiven Polybenzoxazol oder aus einem Polybenzoxazolderivat.

Mit Bezug auf Figur 2 besteht der erfindungsgemäße Unterschied zu Figur 1 darin, daß eine erste dielektrische Schicht 6 zum Auffüllen des Grabens 5 und zum Bedecken der leitfähigen Schicht 2 und damit zum Bedecken der ersten Leiterbahn 3 und der zweiten Leiterbahn 4 verwendet wird. Bei der ersten dielektrischen Schicht 6 handelt es sich beispielsweise um den Polymerwerkstoff Polybenzoxazol. Der erfindungsgemäße Vorteil der ersten dielektrischen Schicht 6 aus Polybenzoxazol besteht in der hervorragenden Fülleigenschaft, der niedrigen Dielektrizitätskonstante, die kleiner als 2,9 ist und der Reduzierung von Reflexionen bei nachfolgenden Lithographieschritten.

Mit Bezug auf Figur 3 wird auf der dielektrischen Schicht 6 die Siliziumnitridschicht 8 gebildet. Im Gegensatz dazu wird bei dem in Figur 2 dargestellten Ausführungsbeispiel zunächst eine Siliziumoxidschicht 7 auf der dielektrischen Schicht 6 und darüber erst die Siliziumnitridschicht 8 gebildet.

Weitere Vorteile bestehen darin, daß die dielektrische Schicht 6 als Streßreduktionsschicht gegenüber der häufig mechanisch verspannten Siliziumnitridschicht 8 wirkt und dadurch Integrationsprobleme, die durch den mechanischen Streß der Siliziumnitridschicht bewirkt werden, reduziert bzw. beseitigt werden. Desweiteren kann die Schichtdicke der dielektrischen Schicht 6 in Figur 3 kleiner ausgebildet werden, als die Schichtdicke der Siliziumoxidschicht 7 aus Figur 1, wodurch nachfolgende Trockenätzschritte zum Öffnen der Passivierungsschicht kürzer und somit wirtschaftlicher durchgeführt werden.

### Bezugszeichenliste

- 1: Grundkörper
- 2: leitfähige Schicht
- 3: erste Leiterbahn
- 4: zweite Leiterbahn
- 5: Graben
- 6: erste dielektrische Schicht
- 7: Siliziumoxidschicht
- 8: Siliziumnitridschicht
- 9: zweite dielektrische Schicht

## Patentansprüche

1. Elektrische Verdrahtung eines integrierten Schaltkreises mit:
- einem Grundkörper (1);
- einer leitfähigen Schicht (2), die auf dem Grundkörper (1) angeordnet ist und so strukturiert ist, daß sie eine erste Leiterbahn (3), eine zweite Leiterbahn (4) und einen Graben (5) zwischen der ersten Leiterbahn (3) und der zweiten Leiterbahn (4) aufweist;
- einer ersten dielektrischen Schicht (6), die auf der leitfähigen Schicht (2) angeordnet ist und den Graben (5) zumindest teilweise ausfüllt,
**dadurch gekennzeichnet,** daß
die erste dielektrische Schicht (6) einen der Polymerwerkstoffe Polybenzoxazol und/oder Polynorbornen und/oder eines ihrer Derivate umfaßt.

2. Elektrische Verdrahtung eines integrierten Schaltkreises nach Anspruch 1,
**dadurch gekennzeichnet,** daß
oberhalb der ersten dielektrischen Schicht (6) eine Siliziumnitridschicht (8) angeordnet ist.

3. Elektrische Verdrahtung eines integrierten Schaltkreises nach Anspruch 2,
**dadurch gekennzeichnet,** daß
zwischen der dielektrischen Schicht (6) und der Siliziumnitridschicht (8) eine Siliziumoxidschicht (7) angeordnet ist.

4. Elektrische Verdrahtung eines integrierten Schaltkreises nach einem der Ansprüche 1 bis 3,
**dadurch gekennzeichnet,** daß
oberhalb der ersten dielektrischen Schicht (6) eine zweite dielektrische Schicht (9) aus dem gleichen Material wie die erste dielektrische Schicht (6) angeordnet ist.

5. Elektrische Verdrahtung eines integrierten Schaltkreises nach einem der Ansprüche 1 bis 4,
**dadurch gekennzeichnet,** daß
das Material der ersten dielektrischen Schicht (6) eine Dielektizitätskonstante kleiner als 3,5 aufweist.

6. Elektrische Verdrahtung eines integrierten Schaltkreises nach einem der Ansprüche 1 bis 5,
**dadurch gekennzeichnet,** daß
der Polymerwerkstoff ein fluoriertes Derivat von Polybenzoxazol, Polynorbornen, Polyimid und/oder Perylen umfaßt.

7. Verfahren zur Herstellung einer elektrischen Verdrahtung eines integrierten Schaltkreises mit den Schritten:
- Bilden einer leitfähigen Schicht (2) auf einem Grundkörper (1) ;
- Strukturieren der leitfähigen Schicht (2), so daß eine erste Leiterbahn (3), eine zweite Leiterbahn (4) und ein Graben (5) zwischen der ersten Leiterbahn (3) und der zweiten Leiterbahn (4) gebildet wird,
**dadurch gekennzeichnet,** daß
eine erste dielektrische Schicht (6) aus einem Polymer auf der leitfähigen Schicht (2) aufgeschleudert wird, so daß der Graben (5) zumindest teilweise aufgefüllt wird, wobei das Polymer Polybenzoxazol und/oder Polynorbornen und/oder eines ihrer Derivate umfaßt.

8. Verfahren nach Anspruch 7,
**dadurch gekennzeichnet,** daß
oberhalb der ersten dielektrischen Schicht (6) eine Siliziumnitridschicht (8) gebildet wird.

9. Verfahren nach Anspruch 8,
**dadurch gekennzeichnet,** daß
zwischen der dielektrischen Schicht (6) und der Siliziumnitridschicht (8) eine Siliziumoxidschicht (7) gebildet wird.

10. Verfahren nach einem der Ansprüche 7 bis 9,
**dadurch gekennzeichnet,** daß
oberhalb der ersten dielektrischen Schicht (6) eine zweite dielektrische Schicht (9) aus dem gleichen Material wie die erste dielektrische Schicht (6) gebildet wird.
